# EUROPEAN PATENT SPECIFICATION

(11) **EP 0 549 795 B1**
(45) Date of publication and mention of the grant of the patent: **14.04.1999**
(21) Application number: 91915980.6
(22) Date of filing: 17.09.1991
(51) Int. Cl.: G11C 16/06

(54) **SEMICONDUCTOR STORING DEVICE**
HALBLEITERSPEICHERANORDNUNG
DISPOSITIF DE MEMORISATION A SEMICONDUCTEUR

(30) Priority: 17.09.1990 JP 246441/90; 17.09.1990 JP 246442/90
(43) Date of publication of application: 07.07.1993
(60) Divisional application: 97122987.7
(73) Proprietor: KABUSHIKI KAISHA TOSHIBA, Kawasaki-shi, Kanagawa-ken 210-8572 (JP)
(72) Inventor: KATO, Hideo, 1044, Kashimada Saiwai-ku, Kanagawa 211 (JP); ASANO, Masamichi, 45-7-308, Denenchofuhoncho, Tokyo 145 (JP); SAITO, Shinji, 649-1, Kasama-cho Sakae-ku, Kanagawa-ken (JP); MATSUDA, Shigeru, 1-1593-18, Kashiwai-cho, Chiba 272 (JP)
(74) Representative: Lehn, Werner, Dipl.-Ing.
(86) International application number: JP9101233
(87) International publication number: WO9205559

(56) References cited:
- EP-A- 0 114 504
- JP-A- 2 009 090
- JP-A- 3 105 795
- JP-A-55 080 343
- JP-A-58 094 196
- JP-A-60 010 497
- JP-A-60 027 158
- JP-A-60 113 397
- JP-A-63 229 698

## Description

### TECHNICAL FIELD OF THE INVENTION

The present invention relates to a semiconductor memory device using electrically erasable non-volatile transistors, and more particularly to a semiconductor memory device suitable for use as semiconductor memory devices capable of operating with a single V_{CC} power source without using an external high voltage power source for data write and erase.

### BACKGROUND OF THE INVENTION

A ROM whose storage contents can be electrically erased and altered is known as an electrically erasable programmable ROM (EEPROM). In erasing the storage contents of an EEPRPOM, an ultraviolet ray is not necessary as different from an EPROM. Therefore, erasing and altering data can be electrically carried out even if an EEPROM is mounted on a board of a configured system.

From this reason and from the viewpoint of easy-to-use, demands for EEPROMs are rapidly increasing for use with various control apparatuses and memory cards.

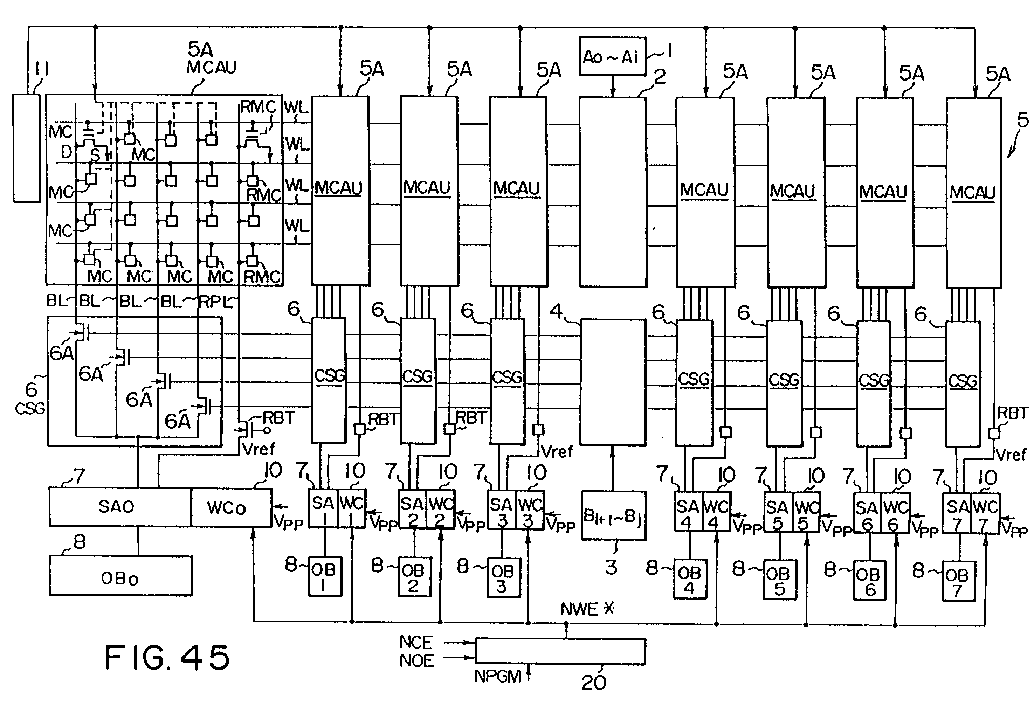

A conventional semiconductor integrated circuit, such as an 8 bit flash type EEPROM, is constructed as shown in Fig. 45.

Referring to Fig. 45, row address signals A_{O} to Aᵢ are inputted to a row address buffer circuit 1 and amplified and shaped by the circuit 1. The amplified and shaped row address signals are then inputted to a row decoder circuit 2. Column address signals Bᵢ₊₁ to Bⱼ are inputted to a column address buffer circuit 3 and amplified and shaped by the circuit 3. The amplified and shaped column address signals are then inputted to a column decoder circuit 4. The row decoder circuit 2 selects only one word line WL of a memory cell array 5 having a plurality of memory cells MC. The column decoder circuit 4 selectively controls a gate 6A of a column select gate circuit 6 to select only one bit line BL of the memory cell array 5 for each I/O unit, totaling up to 8 bit lines BL. In this manner, one memory cell transistor MC for each I/O unit is selected from the memory cell array 5, totaling up to 8 memory cell transistors MC. Information of these eight selected memory cells MC is detected and amplified by each sense amplifier circuit 7. Eight outputs from eight sense amplifier circuits 7 are read via each output buffer circuit 8 at the same time, and outputted to an external circuit.

In the EEPROM shown in Fig. 45, the memory cell array 5 is constructed of eight memory cell array units (MCAU) 5A. For the purpose of simplicity, each unit 5A is shown as having four word lines WL, four bit lines BL, sixteen memory cells MC, and four reference memory cells RMC. In correspondence with the four bit lines BL, four gates 6A are shown in each column select gate circuit 6. One of the gates 6A is turned on by the column decoder circuit 4. The reference memory cell RMC is connected to the sense amplifier (SA) 7 via a reference bit line RBL having a reference gate RBT thereon.

In the EEPROM constructed as above, during each operation cycle, an NCE signal supplied to a write control circuit 10 becomes "0", and during a read cycle an NOE signal becomes "0".

Specifically, in writing 8-bit data in the EEPROM structured as above, each of eight data including "1" and "0" is supplied to an I/O unit for each of eight memory cells via a write data input pad (not shown) commonly used as an output buffer pad. In accordance with the supplied data, the write circuit 10 sets the potential of each bit line BL. Namely, the write circuit 10 applies a high potential for the data "0" and a low potential for the data "1" to the bit line BL selected by the input address signals. At this time, the word line WL selected by the input address signals is set to a high potential.

Namely, in writing the data "0", the selected word line WL and bit line BL are set to the high potential. As a result, hot electrons generated near at the drain D of a memory cell MC are injected to the floating gate FG of the memory cell MC, so that the threshold voltage of the memory cell MC shifts toward the positive side and the data "0" is memorized.

On the other hand, in writing the data "1", the bit line BL is set to the low potential. Therefore, hot electrons will not be injected to the floating gate FG and the threshold voltage of the memory cell MC will not shift, so that the data "1" is memorized.

In erasing data, an output from an erase control circuit 11 causes the erase gate EG to have a high voltage so that electrons injected in the floating gate FG are emitted out to the erase gate EG through the tunneling effect.

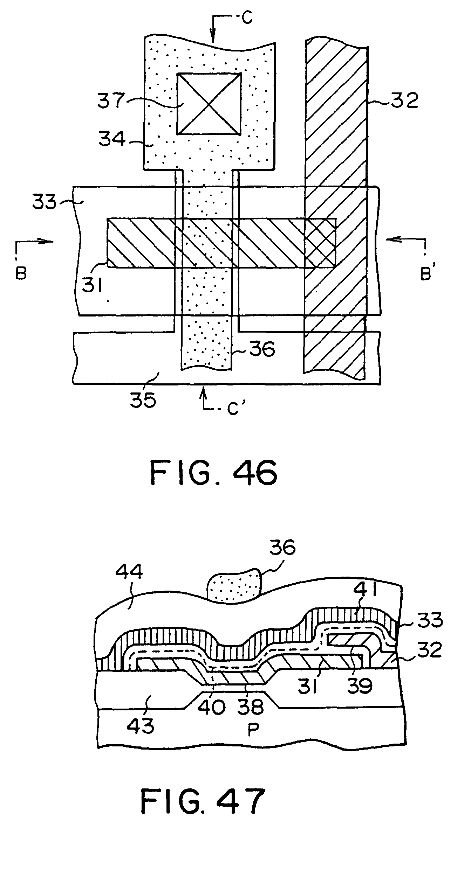

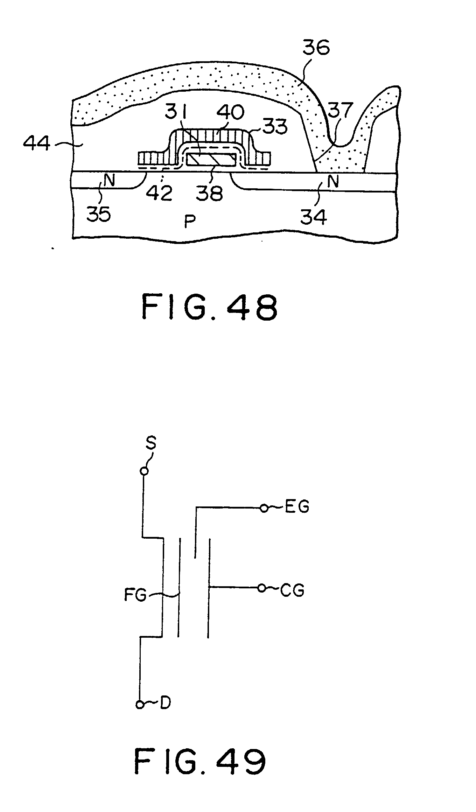

Figs. 46 to 49 show a typical memory cell of such an EEPROM. Fig. 46 is a plan view showing the pattern of a memory cell, Fig. 47 is a cross sectional view taken long line B-B'' of Fig. 46, Fig. 48 is a cross sectional view taken long line C-C' of Fig. 46, and Fig. 49 is an equivalent circuit. In Figs. 46 to 49, reference numeral 31 represents a floating gate electrode of a first polysilicon layer, reference numeral 32 represents an erase gate electrode of a second polysilicon layer, and reference numeral 33 represents a control gate electrode of a third polysilicon layer, serving also as a word line. Reference numerals 34 and 35 represent a drain and source of an N-type diffusion region, respectively, reference numeral 36 represent a bit line of an aluminum layer, reference numeral 37 represents a contact hole for connecting together the drain 34 and bit line 36, reference numeral 38 represents a gate insulating film for a floating gate transistor area, reference numeral 39 represents an erase gate insulating film formed between the floating gate electrode 31 and erase gate electrode 32, reference numeral 40 represents an insulating film of an O-N-O structure (three layer structure of oxide film - nitride film - oxide film) formed between the floating gate electrode 31 and control gate electrode 33, reference numeral 41 represents an insulating film of the O-N-O structure formed between the erase gate electrode 32 and control gate electrode 33, reference numeral 42 represents a gate insulating film of selecting transistor portion with the third polysilicon layer as the gate electrode, reference numeral 43 represents a field insulating film, and reference numeral 44 represents an interlayer insulating film.

The equivalent circuit of the memory cell having the structure described above is shown in Fig. 49. In Fig. 49, S represents a source, D represents a drain, FG represents a floating gate, CG represents a control gate, and EG represents an erase gate. The potential at nodes of the memory cell in various modes are tabulated in Table 1, showing the control gate potential V_{CC}, drain potential V_{D}, source potential V_{S} erase gate potential V_{EG}, and the state of the floating gate.

**Table 1**

| | C.G. | E.G. | D | S | State of F.G. |
|---|---|---|---|---|---|
| Erase | 0V | High Potential | 0V | V | Electron Emission |
| Write "0" | High Potential | 5V | High Potential | 0V | Electron Injection |
| Write "1" | High Potential | 5V | Low Potential | 0V | Electron Injection |
| Read | 5V | 0V | 1V | 0V | |

Table 1 shows the biasing state at each node of the memory cell equivalent circuit.

As seen from Table 1, in erasing data of a memory cell MC, the control gate CG, drain D, and source S are set to 0 V, and the erase gate EC is set to a high potential (e.g., 12 V). In this state, electrons are emitted from the floating gate FG to the erase gate through the Fowler-Nordheim tunneling effect. In this case, current is hardly consumed.

In writing data to a memory cell MC, the control gate CG is set to a high potential, the erase gate EG is set to 5 V, and the source S is set to 0 V. Depending upon the data to be written to the memory cell MC, the drain D is set to a high potential or low potential.

In reading data from a memory cell MC, the control gate CG is set to 5 V, the erase gate EG is set to 0 V, the source S is set to 0 V, and the drain D is set to about 1 V. In this state, whether the memory cell MC turns on, i.e., whether current is caused to flow, is detected by the sense amplifier 7, and the aata in the memory cell MC is read from the output butter 8.

In the following the read cycle which consumes current will be mainly discussed. First, the operation of writing the data "0" to a memory cell will be detailed.

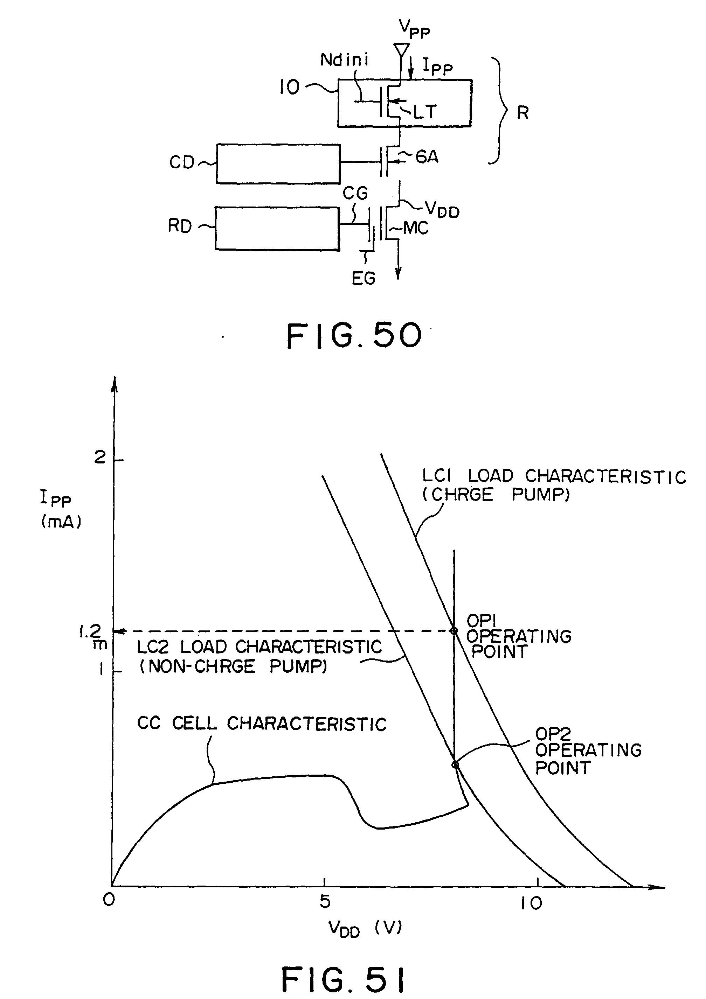

Fig. 50 is a circuit diagram showing part of the write control circuit 10, and the column gate transistor 6 and memory cell MC shown in Fig. 45, to explain the write operation. Fig. 51 is a graph showing the relationship between a current Ipp flowing through a memory cell MC and the drain voltage VDD during the write operation. LT used in Fig. 50 represents a write load transistor of the write circuit 10. The write load transistor LT and column select transistor 6A function as a resistor R which controls the write operating point during the write operation. Specifically, as shown in Fig. 51, the write operation runs on one of cross points OP1 and OP2 between the cell characteristic curve CC and the load characteristic curve LC of the resistor R.

For example, the total resistance of the write load transistor LT and column gate transistor 6A is set to 2.5 kilo-ohms. However, the resistance of the column gate transistor 6A is generally set small in order to read data at a high speed. Therefore, the resistor R is mainly determined by the write load transistor LT.

If the gate voltages of the write load transistor LT and column gate transistor 6A are raised higher than an external write power source voltage Vₚₚ (=12.5 V), this voltage Vₚₚ is directly applied to the drain of the memory cell MC. The load characteristic curve in this state is LC1. At the operating point OP1 intersecting the cell characteristic curve CC and the load characteristic curve LC1, the write current Ipp becomes 1.2 mA as shown in Fig. 51. If the data "0" is written in 8-bit memory cells at the same time, a write current 1.2 mA x 8 bits = 9.6 mA will flow. This write current is supplied from the external write power source Vₚₚ connected to the drain of the write load transistor LT.

Instead of raising the potential at the gates of the column gate transistor 6A and write load transistor LT higher than the write power source voltage Vₚₚ, the potential Vₚₚ itself may be applied to the gates. In this case, the drain voltage of the memory cell MC drops from Vₚₚ by the amount corresponding to the threshold value of the write load transistor LT. The load characteristic curve in this state is LC2. At the operating point OP2, a write current of 0.5 mA will flow.

As described above, a write current during the write operation can be changed by changing the operating point during the write operation.

Demands for a memory LS1 having the above-described memory cell structure are now increasing because it is easy to use. However, the system using such a memory requires not only the power sources V_{CC} and V_{SS} but also the write power source Vₚₚ, resulting in a complicated structure of the system.

Apart from the above, a system using batteries is known, and demands for an EEPROM operating with two power sources V_{CC} and V_{SS} are increasing.

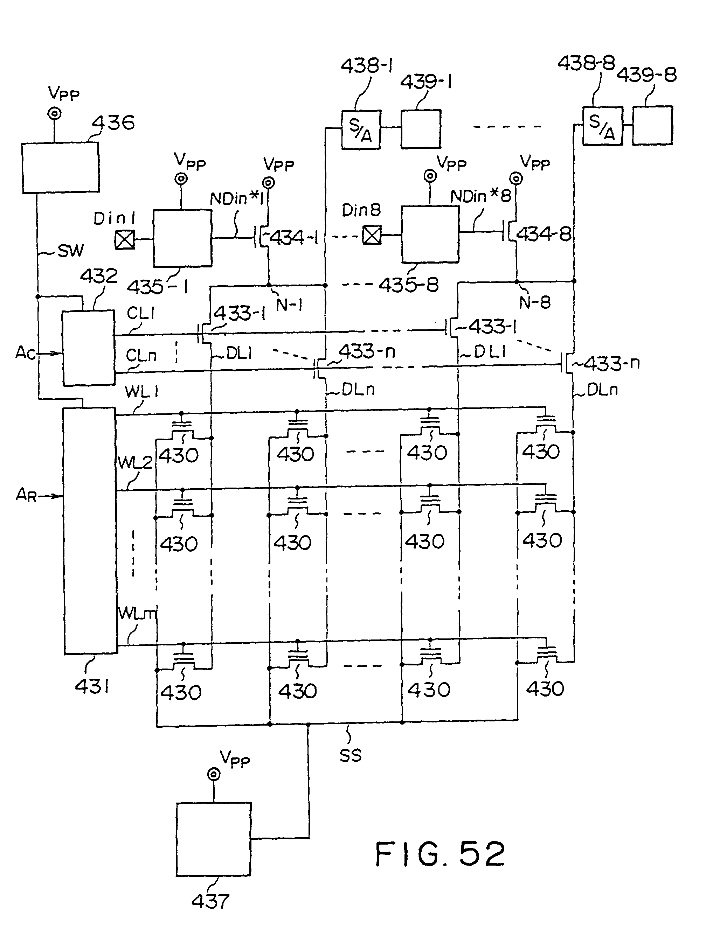

Fig. 52 shows the structure of an EEPROM, or socalled flash type EEPROM using memory cells shown in Figs. 46 to 49. In this example, this EEPROM has a one-byte structure outputting 8 bits. Memory cells 430 are disposed in a m-row, n-column matrix form. The sources of all memory cells are connected in common to a terminal SS. The control gates of a plurality of memory cells are connected to row lines WL1 to WLm which are in turn connected to a row decoder 431. The drains of a plurality of memory cells are connected to column lines DL1 to DLn which are in turn connected to common connection nodes N-1 to N-8 via column select transistors 433-1 to 433-n of an enhancement type whose gates are connected to column select lines CL1 to CLn connected to a column decoder 432. Connected between the common connection nodes N-1 to N-8 and an external high voltage power source terminal Vₚₚ to which a high voltage is applied during the write and erase operations, are write enhancement type load transistors 434-1 to 434-8 to the gates of which outputs NDin*1 to NDin*8 of write data control circuits 435-1 to 435-8 are supplied. The write data control circuits 435-1 to 435-8 are inputted with write data Din1 to Din8 from external terminals, and connected to the write power source terminals Vₚₚ.

In order to supply a high voltage during the write operation, a high voltage from the Vₚₚ terminal is supplied via a high voltage switching circuit 436 to the row decoder 431 and column decoder 432. The common source SS is connected to the output side of a source voltage control circuit 437 to which a high voltage is supplied via the Vₚₚ terminal. Connected to the common connection nodes N-1 to N-8 are sense amplifiers 438-1 to 438-8 having read load transistors. Connected to the output sides of the sense amplifiers 438-1 to 438-8 are output circuit 439-1 to 439-8 which output memory cell data in a output terminals.

The operation of the EEPROM shown in Fig. 52 will be described.

In writing data, a voltage 12 V is applied to the external high voltage power source terminal Vₚₚ. The high voltage 12 V at Vₚₚ terminal is supplied to the row decoder 431 and column decoder 432 via the switching circuit 436. The column select line and row select line selected by address signals A_{C} and A_{R} cause to select one memory cell for each output bit. Namely, in Fig.52, eight memory cells are selected at the same time. The selected row line (e.g., WL1) and column select line (e.g., CL1) are applied with 12 V. In this condition, if the write data Dinl to Din8 are "0", about 9 V is applied from the write data control circuits 435-1 to 435-8 as NDin*1 to NDin*8. As a result, the load transistors 434-1 to 434-8 turn on, and about 6 V is applied to the selected column lines DL1 through a path from Vₚₚ terminal, to load transistors 434-1 to 434-8 and to column select transistors 433-1 to 433-8. On the other hand, if the write data Din1 to Din8 are "1", 0 V is applied as NDin*1 to NDin*8. Therefore, the load transistors 434-1 to 434-8 turn off and the drains of the selected memory cells are not applied with a voltage. The write operation is therefore not executed.

Next, in erasing data, about 12 V is applied to the common source SS from Vₚₚ terminal via the source voltage control circuit 437. Therefore, all column select lines CL1 to CLn and row lines WL1 to Wlm are set to 0 V, thereby erasing data of all memory cells in a flash manner.

In reading data, the write load transistors 434-1 to 434-8 continue to turn off, the SW outputted from the high voltage switching circuit 436 is used as V_{CC} voltage (5 V). Data ("1" or "0") of memory cells selected by the column decoder and row decoder are sensed and amplifiers by sense amplifiers 438-1 to 438-8 and outputted via output circuits 439-1 to 439-8 from external output terminals.

As described above, an EEPROM can use a small size memory cell, and is suitable for memories of a large capacity.

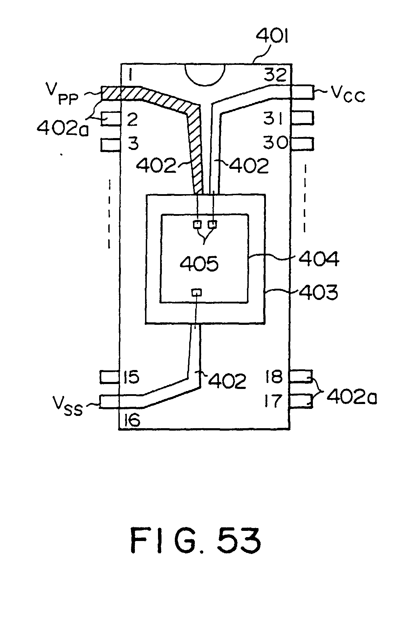

Data is written in an EEPROM through impact ionization. Therefore, the drain current of 8 bit memory cells during the write operation becomes about 5 mA. Also during the erase operation, a current 2 to 3 mA flows from the source to the substrate when a high voltage is applied to the source, because the gate insulating film is thin and a leakage current generates between bands at the junction near the source. It is necessary to provide a high voltage power source having a capability of supplying a large current, as the write and erase high voltage power source Vₚₚ of an EEPROM. It becomes therefore necessary to provide two power sources V_{CC} (5 V) and Vₚₚ (12 V). As shown in Fig. 53, such an EEPROM is provided with a Vₚₚ terminal in addition to V_{cc} terminal and Vₛₛ terminal, and is not easy to use in system configuration. In Fig. 53, reference numeral 401 represents a package, reference numerals 402, 402, ... represent a lead terminal, reference numerals 402a, 402a represent an exposed pin of each lead terminal 402, 402, reference numeral 403 represents a pad, reference numeral 404 represents a chip, and reference numeral 405 represents a bonding wire.

### Summary of the Invention

The present invention has been made under the above-described circumstances. It is an object of the present invention to provide a non-volatile semiconductor memory capable of providing stable read, write and erase operations and reducing a write current during the write operation, even with a single power source for a write power source.

According to the present invention, as defined by claim 1, in writing data into memory cells, data write is not executed for all bits at the same time, but for a predetermined number of memory cells at each time. For example, data write is executed eight times, one bit at a time, for a memory having eight I/O units, or four times two bits at a time. A write current at each time period therefore becomes small, and a power supplied from an internal power source can be used for the data write. A write voltage is boosted by charge pump units of a charge pump circuit, electric charges generated by the charge pump units being stored in capacitors. The write data is latched for a predetermined period in response to a signal from a write control circuit. A write power source is switched by a switching circuit between an internal power source and external power source.

### Brief Description of the Drawings

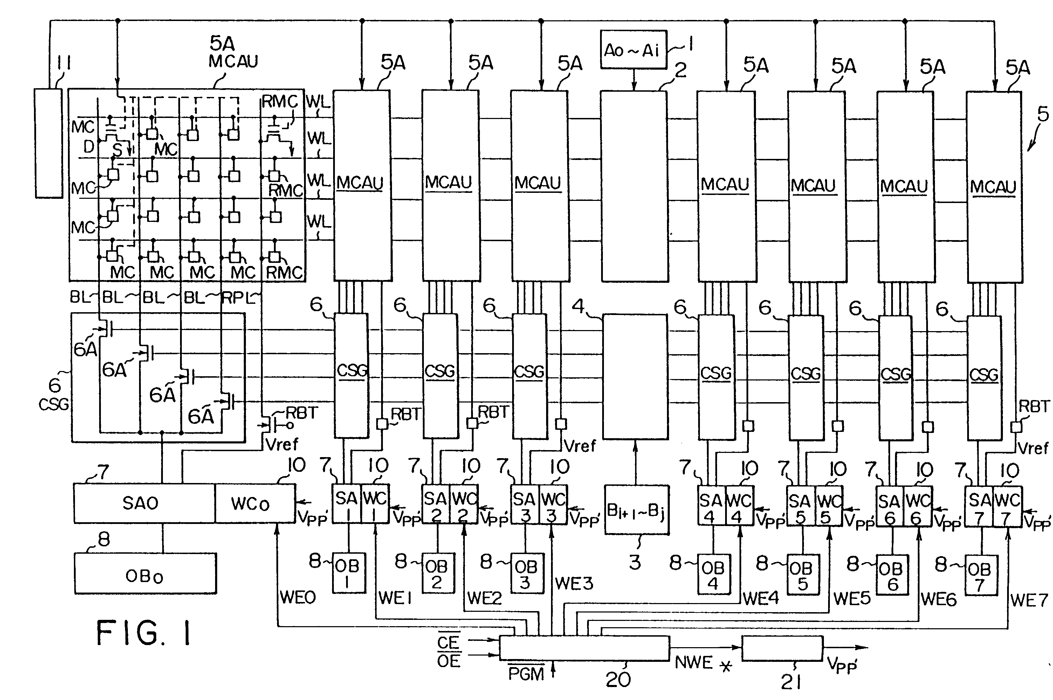

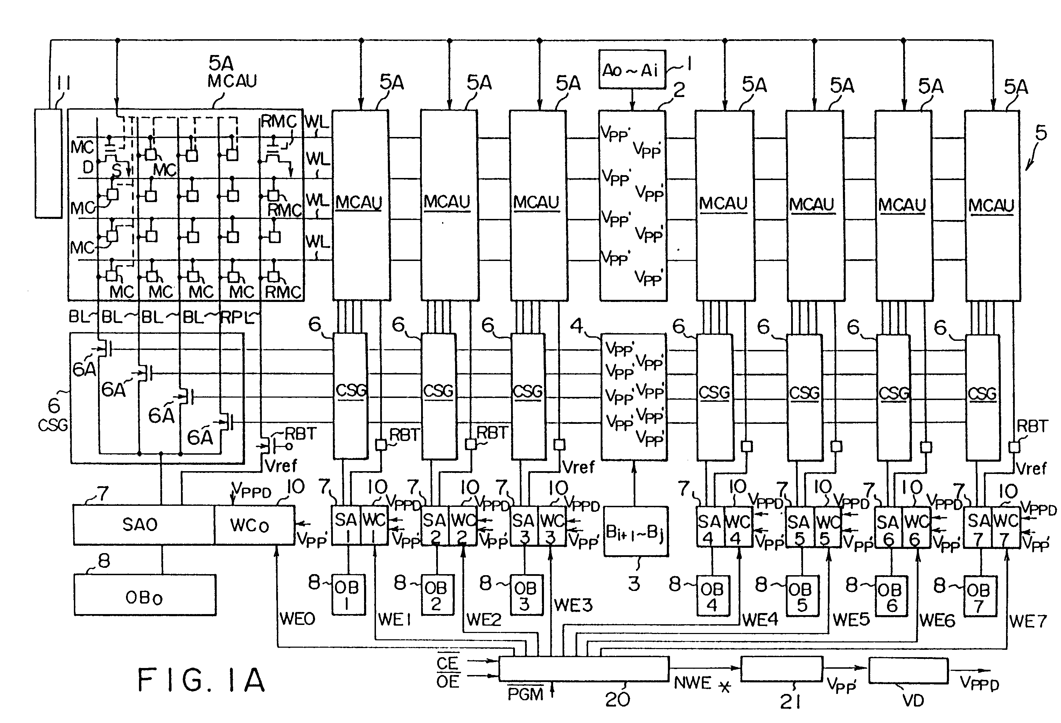

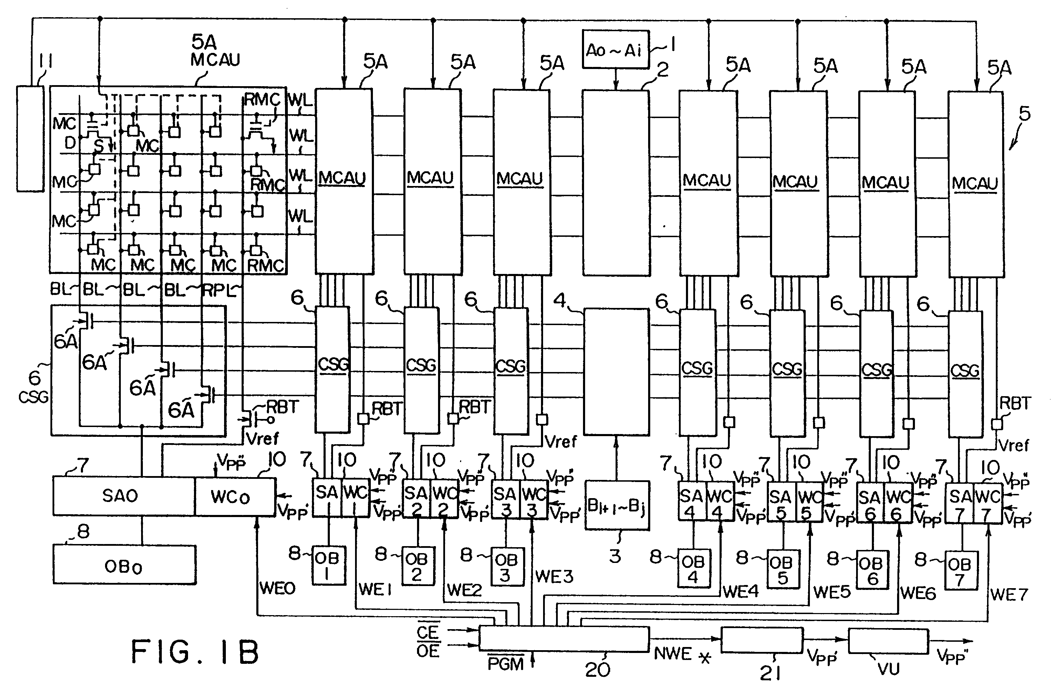

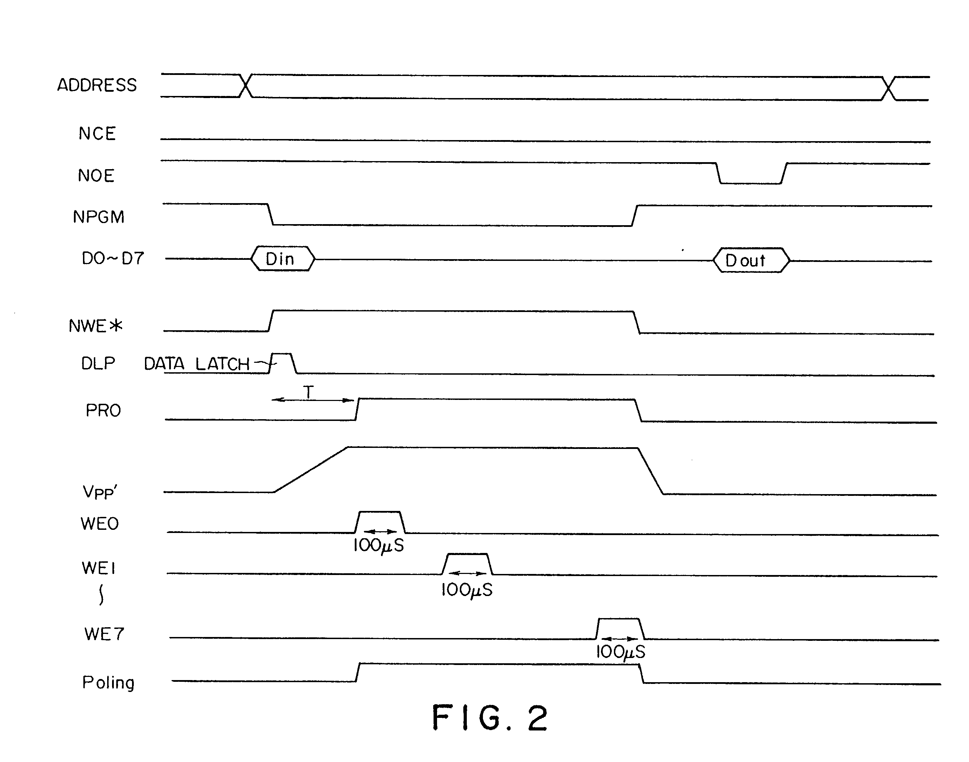

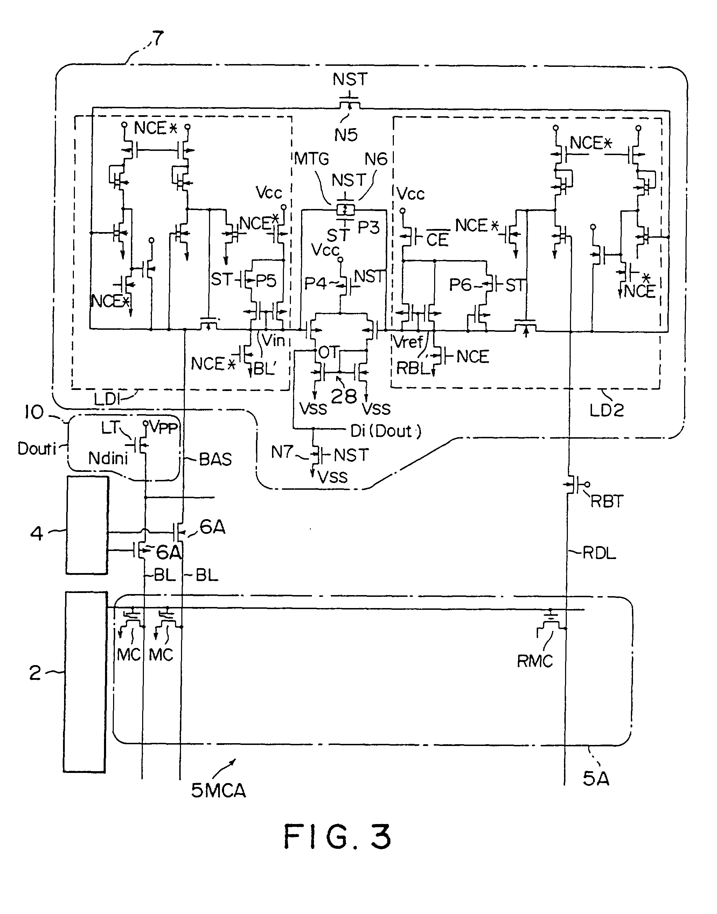

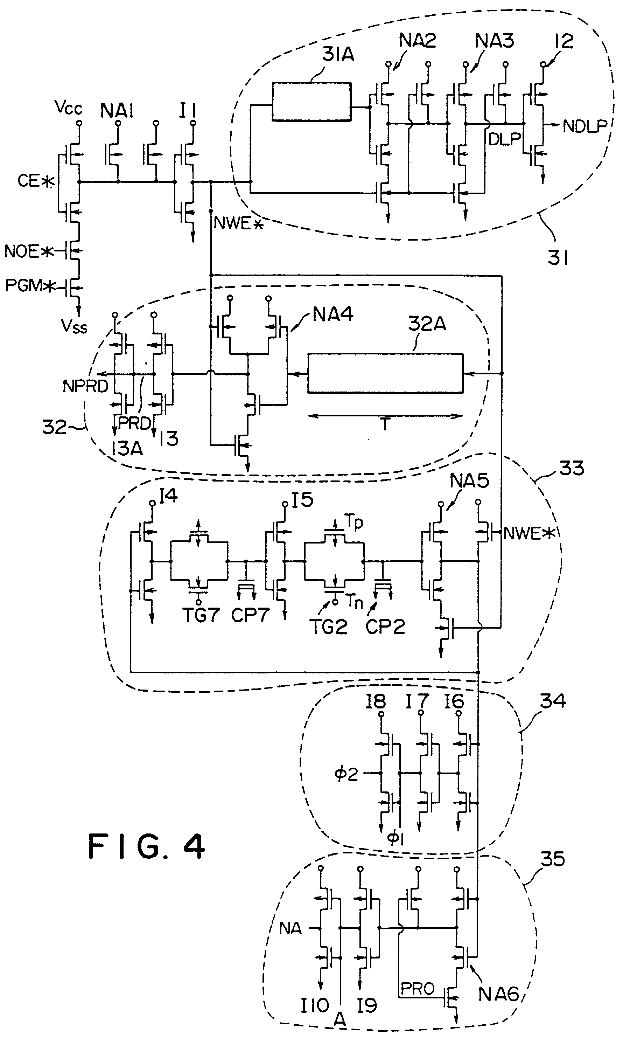

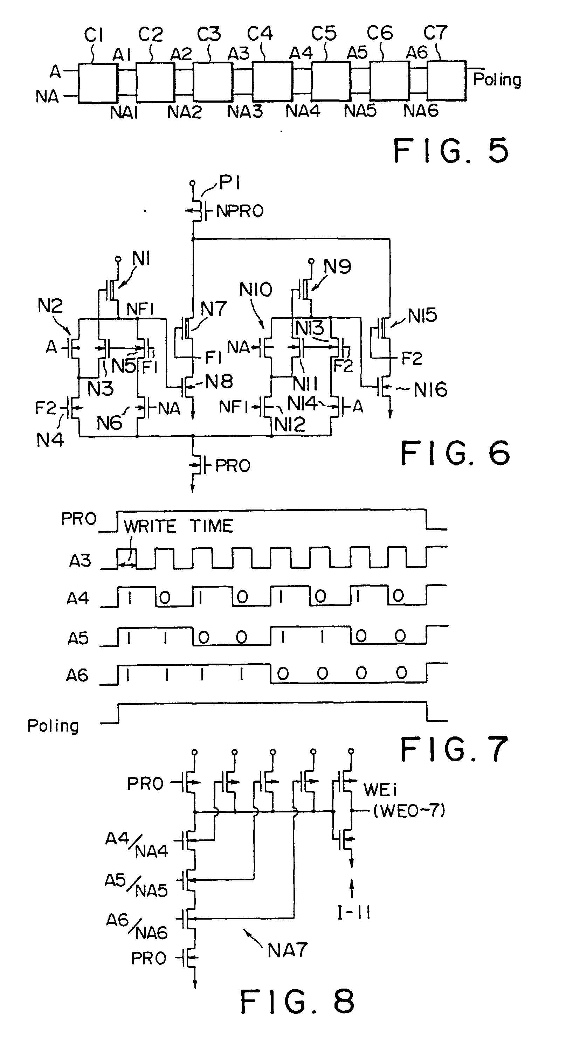

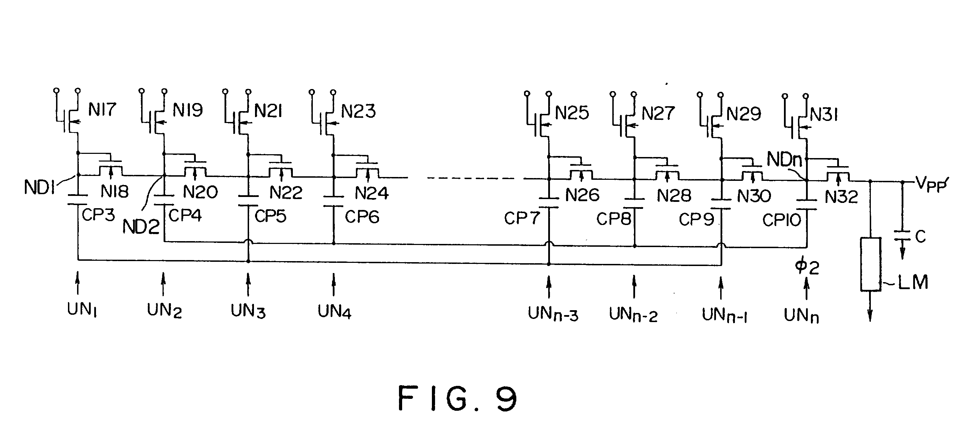

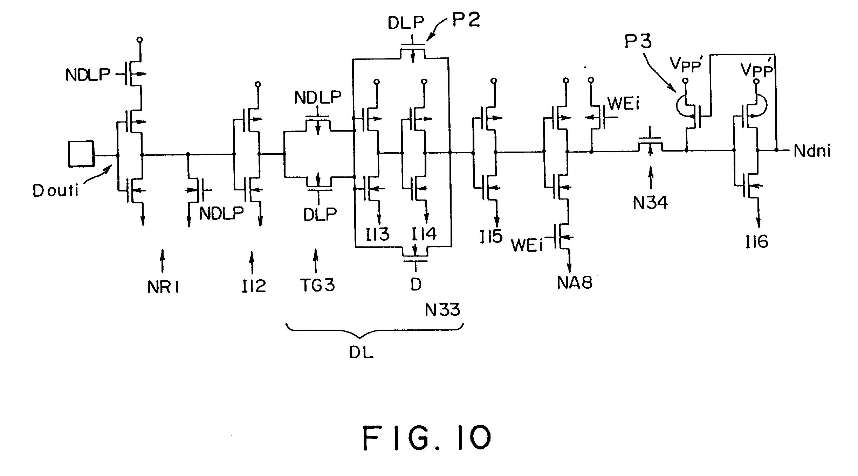

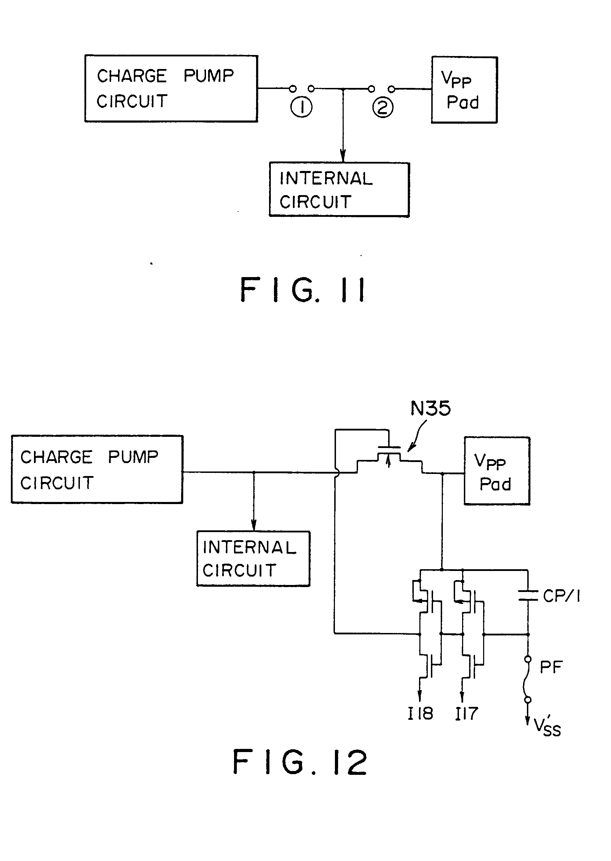

Fig. 1 is a circuit diagram showing the overall structure of an embodiment of the present invention. Fig. 1A is a circuit diagram showing the overall structure of another embodiment of the present invention. Fig. 1B is a circuit diagram showing the overall structure of another embodiment of the present invention. Fig. 2 is a timing chart showing the operation of the embodiment. Fig. 3 is a circuit diagram showing the sense amplifier of the embodiment. Fig. 4 is a charge pump control circuit of the charge pump circuit of the embodiment. Fig. 5 shows a write circuit controller. Fig. 6 is a circuit diagram showing the counter of the controller. Fig. 7 is a timing chart showing the operation timing of the counter. Fig. 8 shows a signal WEi output circuit. Fig. 9 shows a charge pump circuit. Fig. 10 shows a write circuit. Fig. 11 shows an example of switching between power sources. Fig. 12 shows another example of switching between power sources. Figs.13 through Fig. 44 are deleted. Fig. 45 is a circuit diagram showing a conventional memory. Fig. 46 is a plan view showing the pattern of a conventional memory cell. Fig. 47 is a cross sectional view of the conventional memory cell taken along line B-B'. Fig. 48 is a cross sectional view of the conventional memory cell taken along line C-C'. Fig. 49 is an equivalent circuit of the conventional memory cell. Fig. 50 is a circuit diagram showing the main part of the conventional memory cell. Fig. 51 is a graph showing the operation of the main part of the conventional memory cell. Fig. 52 is a circuit diagram showing the structure of a conventional EEPROM, and Fig. 53 is a plan view showing a conventional EEPROM requiring a supply of a program voltage.

### Detailed Description of the Embodiments

Embodiments of the present invention will be described with reference to the accompanying drawings.

Fig. 1 shows an example of a non-volaltile semiconductor memory according to an embodiment of the present invention. Different points from the conventional non-volatile semiconductor integrated circuit shown in Fig. 45 are as follows. In the circuit shown in Fig. 45, a write power is directly supplied to an external power source provided externally of the chip. In contrast with this, in the circuit shown in Fig. 1, a write power to a write circuit 10 is supplied by boosting a power source voltage Vcc by a charge pump circuit 21 formed on the chip. In the circuit shown in Fig. 1, eight bits are sequentially written one bit after another. Namely, in the circuit shown in Fig. 1, control signals WE0 to WE7 are sequentially inputted from a write control circuit 20 to the write circuits 10 in order to sequentially write eight bit data one bit after another.

The structure other than that described above is the same as that shown in Fig. 45. In Fig. 1, like elements to those shown in Fig 45 are represented by using identical reference numerals.

In the circuit shown in Fig. 1, data is read from each memory cell in substantially the same manner as described with Fig. 45. Specifically, referring to Fig. 1, row address signals A_{O} to Aᵢ are inputted to a row address buffer circuit 1 and amplified and shaped by the circuit 1. The amplified and shaped row address signals are then inputted to a row decoder circuit 2. Column address signals Bᵢ₊₁ to Bⱼ are inputted to a column address buffer circuits 3 and amplified and shaped by the circuit 3. The amplified and shaped column address signals are then inputted to a column decoder circuit 4. The row decoder circuit 2 selects only one word line WL of a memory cell array 5 having a plurality of memory cell MC. The column decoder circuit 4 controls a column select gate circuit 6 to select only one bit line BL of the memory cell array 5 for each I/O unit, totaling up to 8 bit lines BL. In this manner, one memory cell transistor MC for each I/O unit is selected from the memory cell array 5, totaling up to 8 memory cell transistors MC. Information of these eight selected memory cells MC is detected and amplified by each sense amplifier circuit 7. Eight outputs from eight sense amplifier circuits 7 are read via each output buffer circuit 8 at the same time, and outputted to an external circuit.

Data is written in the manner described below. In writing data in a memory cell MC, the write control circuit 20 supplies write control signals WE0 to WE7 to a write circuit 10 of each I/O unit, the write control signals controlling the write circuit 10 independently for each bit. Each write circuit 10 enters a write mode in accordance with external control signals NCE, NOE, and NPGM, and generates a pulse signal in order to write data from each I/O unit one bit after another.

The write control circuit supplies a control signal NWE* to the charge pump circuit 21, to boost the power source V_{CC} to a write power source Vₚₚ'. It also generates a write end signal (poling) when the write control signal WEi (WE0 to WE7) causes to sequentially generate the pulse signal and it finally causes to generate the pulse signal for the last bit (I/O 7).

The operation of the memory shown in Fig. 1 will be detailed with reference to the timing chart shown in Fig. 2.

Input address signals A_{O} to Aᵢ and Bᵢ₊₁ to Bⱼ change so as to sequentially write data in memory cells at certain addresses. Memory cells are sequentially selected one after another by the row decoder 2, column decoder 4 and column select gate circuit 6, while selecting one word line of the memory cell array and sequentially selecting a bit line of each I/O unit.

When an input address changes so as to sequentially select a memory cell one bit after another, an external program control signal NPGM changes from "1" to "0". For example, assuming that a logic is implemented in the chip to enter the write mode when the chip control signal NCE is "0", output buffer control signal NOE is "1", and program control signal NPGM is "0", the write mode enters when the signal NPGM changes from "1" to "0". In response to this, the charge pump control signal NWE* changes from "0" to "1", with the internal circuitry of the chip being set to the write mode. The write potential Vₚₚ' is boosted to 13 V for example, so that the charge pump circuit 21 starts operating.

In addition to the above operation, when the charge pump control signal NWE* changes from "0" to "1", a data latch pulse DLP generates for several tens nsec for latching the data to be written in a memory cell in a latch circuit of each I/O unit.

After a predetermined time (T) lapse from when the charge pump control signal NWE* changes from "0" to "1", a program signal PRO changes from "0" to "1". In response to this, the write circuit control signals WEi (WE0 TO WE7) generate in this order for example to control the write circuit 10 for each I/O unit. When the write circuit control signal WEi takes a "1" level, the write circuit 10 supplies a write high or low potential to the bit line BL of the selected memory cell MC, depending upon the data latched by the data latch circuit.

In response to the transition of the program signal PRO to "1" level, a poling signal (Poling) takes a "1" level and outputted to an I/O unit 7 for example, in order to allow a CPU or the like to judge the operation mode as the write mode.

The time duration T from when the charge pump control signal NEW∗ changes to "1" and to when the program control signal PRO changes to "1" is required to be a sufficiently long duration, e.g., about 1 maec, in order to charge the capacitor connected to the output terminal of the charge pump circuit 21.

In this embodiment, this time duration T is set by an internal delay circuit. Instead of this, the program control signal PRO may be arranged to automatically generate when the detected voltage level of the output signal Vₚₚ' of the charge pump circuit 21 is boosted to a predetermined voltage (e.g., 13 V).

The advantageous effects of the memory shown in Fig. 1 will be described.

Conventionally, in a flash type EEPROM using a single power source, a high potential for the write and erase operations is boosted by the charge pump circuit 21 within the chip, and a current particularly for the write operation is stored in the capacitor connected to the output side of the charge pump circuit 21 as electric charges. Therefore, if a write current is large, the boosted write voltage cannot be held for a predetermined time period and it instantly drops.

However, in the memory shown in Fig. 1, in writing data to memory cells during the write mode, each write circuit 10 is activated for each bit under the control of the write circuit control signal WEi. Therefore, a write current only for one bit flows at a time. Electric charges stored in the capacitor connected to the output side of the charge pump circuit 21 are therefore sufficient for supplying a write current, thereby realizing a semiconductor integrated circuit having a large operating margin.

For example, consider the case where the capacitance of the capacitor connected to the output side of the charge pump circuit 21 is 0.2 µF and the potential is boosted up to 13 V as descried above. In this case, a current flowing through a memory cell is 1.2 mA same as the above description, and the write time is assumed to be 100 µs. Since Q = C * V = i * t, 0.2 µF * ΔV = 1.2 mA * 100 µs, and so ΔV = 0.6 V. Therefore, the boosted potential drops only to 13 - 0.6 = 12.4 V during each write time period of 100 µs, sufficient for the data write to a memory cell.

Different from boosting from 5 V to 13 V, boosting from the dropped write voltage of 12.4 V to 13 V is only 0.6 V, resulting in a short boosting time. It is therefore sufficient if the interval between write circuit control signals be set about 100 µs, instead of several ms at the first boosting time period.

In the above embodiment, a write operation at each I/O unit is carried out irrespective of whether the write data is "0" or "1". However, if the write data is the same as that previously stored in a memory cell, the write operation to that I/O unit may be omitted and shipped to the next I/O unit. With such an arrangement, the write time can be reduced advantageously.

Next, particular examples of the sense amplifier 7, write circuit 10 and write control circuit 20 will be briefly described.

Fig. 3 shows an EEPROM using a differential amplifier as a sense amplifier, showing particularly a memory cell array unit MCAU, column select gate 6A and sense amplifier circuit (SA) 7. MC represents a memory cell of a floating gate type MOS transistor, RMC represents a reference memory cell (dummy cell) of a floating gate type MOS transistor, WL represents a word line, BL represents a bit line, RBL represents a reference bit line, reference numeral 2 represents a row decoder, reference numeral 4 represents a column decoder, B6A represents a column select gate transistor, and RTB represents a dummy bit line select transistor equivalent to one column select gate transistor 6A, this transistor being applied with V_{CC} potential at its gate and connected to the reference bit line RBL intermediately thereof. BAS represents a bus line to which column select gate transistors 6A are connected in parallel, LD1 represents a first load circuit connected to the bus line BAS, and LD2 represents a second load circuit connected to the reference bit line RBL. A potential Vin at the bit line BL' at the output side of the first load circuit LD1 and a potential (reference potential) Vref at the reference bit line RBL at the output side of the second load circuit LD2 are applied to a data detector circuit 28 (e.g., constructed of a CMOS current mirror circuit) of the differential amplifier type sense amplifier circuit (SA) 7.

Connected between the first load circuit LD1 and second load circuit LD2 is an N-channel transistor N5 with an NST signal being applied to its gate. Connected between bit line BL' and the reference bit lines RBL' (between two input terminals of the data detector circuit 28) is a CMOS transfer gate MTG constructed of parallel connected P-channel transistor P3 and N-channel transistor N6, the transistor P3 being applied with a signal ST at its gate and the transistor N6 being applied with the inverted signal NST.

In the sense amplifier circuit (SA) 7, connected between the V_{CC} power source and the data detector circuit 28 is an activation control P-channel transistor P4 with the inverted signal NST being applied to its gate. When the transistor P4 turns off, the data detector circuit 28 becomes inactive to reduce consumption current. Connected between the output terminal OT of the data detector circuit 28 and ground is an N-channel transistor N7 with the inverted signal NST being applied to its gate. The first load circuit LD1 has a P-channel transistor P5 to which gate the signal ST is applied. The second load circuit LD2 has a P-channel transistor P6 to which gate the signal ST is applied.

In the circuit constructed as shown in Fig. 3, the reference potential Vref at the reference bit line RBL' generated in accordance with the data in the reference memory cell RMC is compared by the sense amplifier circuit with the potential Vin at the bit line BL' generated in accordance with the data read from the selected memory cell. The comparison result is used to detect the data stored in the memory cell, and to output the stored data to the output buffer circuit 8.

As compared with a data read speed of a memory cell after an address signal changes, a data read speed of a memory cell after a chip enable signal changes is slow, because an internal chip enable signal becoming active in a chip enable buffer circuit has some time delay. The signals ST and NST are provided to solve such a problem. Namely, the signals ST and NST are used in order to read data from a memory cell at a high speed when a chip control signal changes. The signals ST and NST are also used in order to control the potential at the bit line via which data is read from a memory cell. The signal St and its inverted signal NSt are also used in order to set the potential at the bit line via which data is read from a memory cell, to an intermediate level between the data "1" and "0". The potential of the bit line is set to this intermediate level by using the signal ST and its inverted signal NST, during the period that after the chip control signal changes, the cell data is transferred to the bit line. In this case, the data read from a memory cell onto the bit line changes from the intermediate level to "1" or "0" level potential. As a result, the time required for the data on the column line to change is halved, allowing a high speed data read. While the potential at the bit line takes the intermediate level, the sense amplifier circuit SA detects the intermediate level. However, this level is not the correct data. Therefore, during this period, the signal ST takes "0" level to disable the sense amplifier circuit SA.

The write control circuit 20 is constructed of a charge pump control circuit and a write circuit controller. Fig. 4 shows a charge pump circuit, and Figs. 5 to 8 shows a write circuit controller.

First, the charge pump control circuit shown in Fig. 4 will be described. An internal chip enable signal CE* is a signal generated by a chip enable buffer circuit (not shown) by using the external chip enable signal NCE, this signal CE* being used for activating the integrated circuit chip or making it enter a stand-by state. A signal NOE* is a signal generated by an out enable buffer (not shown) by using the external out enable control signal NOE, this signal NOE* being used for activating the output buffer circuit or making it enter a high impedance state. A signal PGM* is an internal signal generated by a PGM buffer circuit (not shown) by using the external program control signal PGM. V_{CC} represents a power source potential, and V_{SS} represents a ground potential.

The signals CE*, NOE* and PGM* are inputted to a three-input NAND gate NA1 whose output is supplied to an inverter 11. An output NWE* of the inverter L1 is supplied to a data latch pulse generator circuit 31, a program signal generator circuit 32 and a ring oscillator circuit 33.

In the latch pulse generator circuit 31, the signal NWE* is inputted to a first delay circuit 31A. An output (same phase with the input) of this delay circuit 31A and the signal NWE* are supplied to a two-input NAND gate NA2. An output of the NAND gate NA2 and the signal NWE* are supplied to a two-input NAND gate NA3. An output of the gate NA3 is supplied to an inverter I2. An output DLP of the NAND gate (NOR gate) NA3 and an output NDLP (inverted signal) of the inverter I2 control the data latch circuit.

In the program signal generator circuit 32, the signal NWE* is inputted to a second delay circuit 32A. An output (same phase with the input and delayed by a predetermined time duration T) of the delay circuit 32A and the signal NWE* are supplied to two-input NAND gate NA4. An output of the this gate NA4 is supplied to inverters I3 and I4. Output signals PRO and NPRO (inverted signal) control the write circuit controller.

The ring oscillator circuit 33 has a two-input NAND gate NAS to which an output of a transfer gate TG2 and the signal NWE* are supplied. This transfer gate TG2 is constructed of an n-channel transistor Tn and p-channel transistor Tp connected in parallel, the transistor Tn being applied with V_{CC} potential at its gate and the transistor Tp being applied with V_{SS} potential at its gate. An output of the NAND gate NAS is applied via an inverter I4 to one end of a transfer gate TG1 having the same configuration as the transfer gate TG2. The other end of the transfer gate TG1 is connected to one end of the transfer gate TG2 via an inverter I5. The one ends of the transfer gates TG1 and TG2 are connected to n-channel transistors CP1 and CP2 with V_{SS} potential applied to their drains.

An output of the ring oscillator circuit 33 is supplied to a charge pump clock pulse circuit 34 and a write load control circuit clock pulse circuit 35. In the charge pump clock pulse circuit 34, an output of the ring oscillator circuit 33 is supplied to an inverter I6. An output of the inverter I6 is coupled to two stage inverters I7 and I8. Output φ1 and φ2 (= Nφ) of the inverters I7 and I8 are supplied to the charge pump circuit 21.

The write load control circuit clock pulse circuit 35 has a two-input NAND gate NA 6. Supplied to this gate NA6 are an output of the ring oscillator circuit 33 and an output PRO of the program signal generator circuit 32. An output of the NAND gate NA6 is connected to two state inverters I9 and I10. Outputs A and NA of the inverters I9 and I10 are supplied to the write control circuit 20.

In the charge pump control circuit shown in Fig. 4, when the signals CE*, NOE* and PGM* take "1" level, the write mode is effected and the signal NWE* takes "1" level. Thereafter, as seen also from Fig. 2, the data latch pulse pulse signal DLP takes "1" level for a predetermined time duration determined by the first delay circuit 31A, and the program signal PRO takes "1" level after the delay time T of the second delay circuit 32A. In addition to the above operations, when the signal NWE* takes "1" level, the ring oscillator circuit 33 starts oscillating at a predetermined frequency, and the clock pulse circuit 33 generates the clock pulse signals φ1 and φ2 synchronously with the frequency of the ring oscillator circuit 33. When the program signal PRO takes "1" level, the write load circuit clock pulse circuit generates the clock pulse signals A and NA synchronously with the frequency of the ring oscillator circuit 33.

In the write circuit controller shown in Fig. 5, counter circuits C1 to C7 are connected in series. The counter circuits C1 and C7 all have the same structure. The counter circuit C1 for example has the structure shown in Fig. 6 to be described later in detail. The outputs A and NA of the charge pump control circuit shown in Fig. 4 are inputted to the first state counter circuit C1. Outputs F1 and NF1 of the first stage counter circuit C1 are supplied to the second state counter circuit C2. The other counter circuits C3 and C7 operate in the similar manner. The seventh state counter circuit C7 outputs a poling signal Poling. The outputs of the counter circuits C3 to C7 are shown in Fig. 7. As shown in Fig. 8, the outputs A4, NA4, A5, NA5, A6, and NA6 of the fourth to sixth stage counter circuits C4, C5, and C6 and the program signal PRO are inputted to a four-input NAND gate NA7. An output of the NAND gate NA7 is supplied to an inverter Ill which outputs the write circuit control signal WEi. Namely, each state of the counter circuits generates a pulse having a period twice as long as that of the fundamental clocks A and NA. The number of counter circuits is determined so as to obtain a clock width necessary for data write (e.g., three stages). In this manner, a pulse having a predetermined write period can be set. For example, by using the outputs of the fourth to sixth counter circuits C4 to C6, the signal WEi for the sequential control of the eight I/O units can be obtained. Specifically, a signal outputted from the NAND gate NA7 is supplied to the write circuit 10, the signal including WE0 with A4, A5 and A6 all being set to "1" level, WE1 with A4 being set to "0" level, A5 and A6 being set to "1" level, and WE7 with A4, A5 and A6 all being set to "0" level.

An example of the detailed circuit of the counter circuits C1 to C7 is shown in Fig. 6. As seen from Fig. 6, the counter circuits C1 to C7 are constructed by using a known circuit which receives A and NA and outputs F1 and NF1. In the case of the counter circuit C1, F1 and NF1 correspond to A1 and NA1.

Fig. 9 shows an example of the charge pump circuit 21. In this charge pump circuit, n-stage charge pump units UN₁ to UNₙ are connected in series. The unit UN₁ has an n-channel transistor N17 whose drain and gate are connected to the power source V_{CC}. The source of the transistor N17 is connected to the gate and drain of an n-channel transistor N18. A connection node (ND1) between the transistors N17 and N18 is connected to one end of a capacitor CP3 the other end of which is inputted with the signal φ1 from the charge pump control circuit shown in Fig. 4. The unit UN₂ has an n-channel transistor N18 whose drain and gate are connected to the power source V_{CC}. The source of the transistor N18 is connected to the gate and drain of an n-channel transistor N20. A connection node (ND2) between the transistors N19 and N20 is connected to one end of a capacitor CP4 the other end of which is inputted with the signal φ2 from the charge pump control circuit. The other units UN₃ to UNₙ have the same structure as above. Namely, the odd numbered units have the same structure as the unit UN₁, and the even numbered units have the same structureas the unit UN₂. An output of the last stage unit UNₙ is a boosted voltage Vₚₚ'. Connected to this last output terminal are a charge storing capacitor C and a limiter circuit LM for limiting the boosted voltage to a predetermined potential.

In the charge pump circuit shown in Fig. 9, during the operation cycle other than the write cycle, the charge pump control circuit does not generate the clock signal outputs φ1 and φ2, so that the potential at each node ND1 to NDn is V_{CC} - Vₜₕₙ (Vₜₕₙ is a threshold voltage of the n-channel transistor). When the write mode enters from this condition, the clock signals φ1 and φ2 generate and oscillate between the potentials 0 V and V_{CC}. As a result, the potential at the first stage node ND1 oscillates between the level V_{CC} - Vₜₕₙ and level 2V_{CC} - Vₜₕₙ. The potential at the second stage node ND2 oscillates between the level 2V_{CC} - Vₜₕₙ and level 3V_{CC} - Vₜₕₙ. In this manner, the potential is boosted up gradually from the power source V_{CC}.

Fig. 10 shows a write load circuit. In this circuits, Dₒᵤₜᵢ is a data input to be written to a memory cell. The data input Dₒᵤₜᵢ and data latch pulse NDLP are inputted to a two-input NOR gate NR1. An inverter I12 is connected to the output side of the NOR gate NR1. A transfer gate TG3 is connected to the output side of the inverter I12. This gate TG3 is constructed of a p-channel transistor and n-channel transistor connected in parallel, the p-channel transistor being applied with the latch signal NDLP at its gate and the n-channel transistor being applied with the latch signal DLP at its gate. Three-stage inverters I13 to I15 are connected to the output side of the transfer gate TG3. Connected between the input side of the inverter I13 and the output side of an inverter I14, are a p-channel transistor p2 with the latch signal DLP being applied to its gate and an n-channel transistor N33 with the latch signal NDLP being applied to its gate. A data latch circuit DL for latching data to be written in a memory cell is constructed of the inverters I13 and I14, transfer gate TG3, p-channel transistor P2, and n-channel transistor N2. An output of the inverter I15 and the write circuit control signal WEi are inputted to a two-input NAND gate NAB. The output side of the inverter I15 is connected to an inverter I16 via an n-channel transistor N34 with the power source V_{CC} being applied to its gate. Also connected to the input side of the inverter I16 are a p-channel transistor P3 with an output Vₚₚ' of the charge pump circuit being applied to its drain and an output of the inverter I16 being applied to its gate. An output Ndini of the inverter I16 is applied to the gate of the write load transistor.

In the write circuit 10 shown in Fig. 10, when the signal NWE* takes "1" level, the latch signal DLP takes "1" level, and the signal NDLP takes "0" level, then the NOR gate NR1 and transfer gate TG3 are activated. As a result, the write data Dₒᵤₜᵢ is latched by the latch circuit DL. When the latch signal DLP takes "0" level, the signal NDLP takes "1" level, and the transfer gate TGS becomes off, then the p-channel transistor p2 and n-channel transistor N33 turn on to latch the data in the latch circuit DL.

Next, consider the bit relative to which the write circuit control signal WEi takes "1" level. In accordance with the data latched by the activated latch circuit, the NAND gate NA8 causes the output Ndini to take a high potential when the input Douti is "0" level, and a low potential when the input Dₒᵤₜᵢ is "1" level.

As described above, with the memory system shown in Fig. 1, the write operation can be sufficiently carried out even with a signal power source. However, the write time is longer than that when data is written to all bits at the same time.

There is a case where a user prefers a shorter write time by supplying a write potential Vₚₚ externally, rather than a longer write time by using only a single power source V_{CC} in the system configuration.

Therefore, depending upon the application of a memory system, the write voltage may be selectively obtained either from voltage boosted by a charge pump circuit within the chip or from an external power source. Examples of such an arrangement are shown in Figs. 11 and 12.

Fig. 11 schematically illustrates a method of switching a write potential supplied to the internal circuit by using an Al mask which is used at one of the semiconductor manufacturing steps, an A1PEP process. Specifically, if an output of a charge pump circuit is used as the write voltage, an Al mask for closing the contacts (1) is used, whereas if an external power source is used, another Al mask closing the contacts (2) is used. This method shown in Fig. 11 has a small degree of freedom because Al masks are required to be selectively used.

A method illustrated in Fig. 12 is an improved version of the method shown in Fig. 11. An n-channel transistor N35 is formed between a terminal from which a voltage is supplied to the internal circuit and an external power source pad. The gate of this transistor N35 is supplied with an output of an inverter I18. The input side of the inverter I18 is connected to the ground terminal V_{SS} via an inverter I17 and poly-fuse PF. The external power source Vₚₚ is connected to one ends of the inverters I17 and I18, and the ground terminal V_{SS} is connected to the other ends thereof. A capacitor CP11 is connected between the external power source Vₚₚ and the poly-fused PF.

An output of the inverter I18 is supplied to the gate of the n-channel transistor N35. If the poly-fuse PF is not made blown, an output of the inverter I18 takes "0" level. Therefore, the n-channel transistor N35 is always off to disconnect the external power source PAD from the internal circuit. If the poly-fuse PF is made blown, the inverter I18 outputs the same potential as that of the external power source PAD. As a result, during the write mode providing the high potential, the n-channel transistor N35 becomes on so that the external power source PAD is used as the write power source.

Instead of the poly-fuse PF, a memory cell such as an EEPROM or EPROM may be used to make the data write state or not correspond to the on-state or off-state of the poly-fuse PF.

With the above system arrangement, it is easy to select the write voltage either from the external power source Vₚₚ for high speed data write or from the single power source irrespective of a longer write time.

## Claims

1. A semiconductor memory device having a memory cell array with a plurality of memory cells (MC) disposed in a row direction and in a column direction, each memory cell being constituted by a transistor capable of electrically altering data, comprising:
a plurality of data detector circuits (28) for detecting data in each said memory cell;
a plurality of output buffer circuits (8) each connected to each said data detector circuit;
a plurality of write circuits (10) for supplying a write voltage during a data write to each said memory cell; and
an erase control circuit for supplying an erase voltage to each said memory cell;
**characterized** by
a write control circuit (20) for sequentially activating at intervals of delayed timings a predetermined number of said plurality of write circuits;
a charge pump circuit (21) for boosting an internal power source voltage (Vcc) to generate said write voltage and said erase voltage; and
a voltage limiter circuit (LM) for controlling an output voltage of said charge pump circuit (21) to have a predetermined value.

2. A semiconductor memory device according to claim 1, wherein said charge pump circuit (21) comprises a charge pump unit for internally boosting said internal power source voltage (Vcc) and a capacitor (C) connected to said charge pump unit (UN₁-UNₙ) for holding electric charges supplied from said charge pump unit.

3. A semiconductor memory device according to claim 1, wherein said write circuit includes a latch circuit for a predetermined time period, in accordance with a write enable signal from said write control circuit (20).

4. A semiconductor memory device according to claim 1, further comprising switching means for operating to select one of said internal charge pump circuit (21) and an external power source in supplying said write voltage and said erase voltage.

## Patentansprüche

1. Halbleiterspeichervorrichtung mit einer Speicherzellenanodnung mit einer Vielzahl von in einer Zeilenrichtung und in einer Spaltenrichtung angeordneten Speicherzellen (MC), wobei jede Speicherzelle durch einen Transistor für ein elektrisches Verändern von Daten gebildet ist, umfassend:
eine Vielzahl von Datenerfassungsschaltungen (28), um Daten in jeder Speicherzelle zu erfassen;
eine Vielzahl von Ausgabepufferschaltungen (8), jede mit jeder Datenerfassungsschaltung verbunden;
eine Vielzahl von Schreibeschaltungen (10), um während eines Datenschreibens eine Schreibspannung zu jeder Speicherzelle zu liefern; und
eine Lösch-Steuerschaltung, um eine Löschspannung an jede Speicherzelle anzulegen;
**gekennzeichnet** durch
eine Schreibsteuerschaltung (20), um sequentiell in Intervallen mit verzögerten Zeitvorgaben eine bestimmte Anzahl der Vielzahl von Schreibschaltungen zu aktivieren;
eine Ladungspumpschaltung (21), um eine interne Energiequellenspannung (Vcc) zu verstärken, um die Schreibspannung und die Löschspannung zu erzeugen; und
eine Spannungsbegrenzungsschaltung (LM), um eine Ausgangsspannung der Ladungspumpenschaltung (21) zu steuern, so daß diese einen vorbestimmten Wert aufzuweist.

2. Eine Halbleiterspeicherschaltung nach Anspruch 1, dadurch gekennzeichnet, daß die Ladungspumpschaltung (21) eine Ladungspumpeinheit für ein internes Verstärken der internen Energiequellenspannung (Vcc) und einen Kondensator (C) umfaßt, der mit der Ladungspumpeinheit (IN₁-UNₙ) verbunden ist, um von der Ladungspumpeinheit gelieferte elektrische Ladungen zu halten.

3. Eine Halbleiterspeicherschaltung nach Anspruch 1, dadurch gekennzeichnet, daß die Schreibschaltung eine Halteschaltung für eine vorbestimmte Zeitperiode in Übereinstimmung mit einem Schreibfreigabesignal von der Schreibsteuerschaltung (20) einschließt.

4. Eine Halbleiterspeicherschaltung nach Anspruch 1, weiter eine Schaltvorrichtung umfassend, um eine interne Ladungspumpschaltung (21) oder eine externe Energiequelle zum Liefern der Schreibspannung und der Löschspannung auszuwählen.

## Revendications

1. Dispositif semi-conducteur à mémoire comprenant un réseau de cellules de mémoire (MC) disposées en rangées et en colonnes, chaque cellule de mémoire étant constituée d'un transistor capable de modifier électriquement les données, comprenant:
plusieurs circuits (28) détecteur de données, pour détecter les données dans chaque cellule de mémoire;
plusieurs circuits tampons de sortie (8) connectés chacun à chaque circuit détecteur de données;
plusieurs circuits d'écriture (10) pour fournir une tension d'écriture, pendant une opération d'écriture de données, à chaque cellule de mémoire, et
un circuit de commande de l'opération d'effacement pour fournir une tension d'effacement à chaque cellule de mémoire;
caractérisé par
un circuit de commande de l'opération d'écriture (20) pour activer séquentiellement, à intervalles de temporisation, un nombre prédéterminé desdits plusieurs circuits d'écriture;
un circuit (21) de pompage de charge pour survolter la tension d'une source d'énergie interne (Vcc) pour générer ladite tension d'écriture et ladite tension d'effacement; et
un circuit limiteur de tension (LM) pour commander une tension de sortie dudit circuit (21) de pompage de charge pour qu'il présente une valeur prédéterminée.

2. Dispositif semi-conducteur à mémoire selon la revendication 1, dans lequel ledit circuit (21) de pompage de charge comprend une unité de pompage de charge pour survolter de manière interne la tension de ladite source de d'énergie interne (Vcc), et un condensateur (C) relié à ladite unité de pompage de charge (UN₁-UNₙ) pour conserver des charges électriques fournies par ladite unité de pompage de charge.

3. Dispositif semi-conducteur à mémoire selon la revendication 1, dans lequel ledit circuit d'écriture comprend un circuit de maintien pour une période temporelle prédéterminée, en accord avec un signal de validation de l'écriture provenant dudit circuit de commande de l'opération d'écriture (20).

4. Dispositif semi-conducteur à mémoire selon la revendication 1, comprenant de plus un moyen de commutation destiné à choisir l'un parmi ledit circuit (21) de pompage de charge interne et une source d'énergie externe pour fournir ladite tension d'écriture et ladite tension d'effacement.
